# EUROPÄISCHE PATENTSCHRIFT

(11) **EP 4 114 149 B1**
(45) Veröffentlichungstag und Bekanntmachung des Hinweises auf die Patenterteilung: **29.07.2026**
(21) Anmeldenummer: 22192045.7
(22) Anmeldetag: 20.06.2018
(51) Int. Cl.: H05K 3/40, H05K 3/00, H05K 3/12, H05K 1/16

(54) **VERFAHREN ZUM ERZEUGEN EINER DURCHKONTAKTIERUNG IN EINER BEIDSEITIG BEDRUCKTEN TRÄGERFOLIE**
METHOD FOR PRODUCING A THROUGH-HOLE IN A DOUBLE-SIDED PRINTED CARRIER SHEET
PROCÉDÉ DE PRODUCTION D'UNE CONNEXION TRANSVERSALE DANS UNE FEUILLE PORTEUSE IMPRIMÉE DES DEUX CÔTÉS

(30) Priorität: 20.06.2017 DE 102017210217
(43) Veröffentlichungstag der Anmeldung: 04.01.2023
(62) Teilanmeldung aus: 18746566.1
(73) Patentinhaber: Bundesdruckerei GmbH, 10969 Berlin (DE)
(72) Erfinder: Ferber, Alexander, 12105 Berlin (DE)
(74) Vertreter: GLAWE DELFS MOLL

(56) Entgegenhaltungen:
- DE-A1- 102011 016 512
- DE-T2- 69 919 008
- US-A- 5 266 904
- US-A1- 2012 111 841
- US-B1- 6 353 420
- VENKAT S: "LASER DRILLED MICROVIAS PRESENT AND FUTURE LASER DRILLING PROMISES EVEN FASTER, MORE FLEXIBLE AND ECONOMICAL MICROVIA MANUFACTURING IN THE FUTURE", CIRCUITREE, CIRCUITREE PUB., SANTA CLARA, CA, US, vol. 13, no. 10, 1 October 2000 (2000-10-01), XP001023572, ISSN: 1059-843X

## Beschreibung

Die Erfindung betrifft ein Verfahren zum Erzeugen einer Durchkontaktierung in einer beidseitig bedruckten Trägerfolie sowie eine beidseitig bedruckte Trägerfolie mit Durchkontaktierung.

Mit Leiterbahnen bedruckte Trägerfolien sind im Stand der Technik bekannt. So umfassen bspw. RFID-Etiketten ("radio frequency identification"-Etiketten bzw. Etiketten zur Identifizierung mit Hilfe elektromagnetischer Wellen) eine Antenne in Form einer auf einer Folie gedruckten Leiterbahn, die mit einem RFID-Chip verbunden ist und sowohl der Energieversorgung als auch der Kommunikation mit einem RFID-Lesegerät dient. Die Leiterbahn ist häufig spulenförmig ausgestaltet und ist an zwei voneinander entfernten Antennenabgriffen mit entsprechenden Kontakten des RFID-Chips verbunden.

Bei ausreichend großen RFID-Chips ist es möglich, die beiden Antennenabgriffe direkt mit dem RFID-Chip zu verbinden, indem der RFID-Chip unmittelbar auf die spulenförmige Leiterbahn aufgesetzt wird, wodurch zwei voneinander entfernt angeordnete Kontakte des RFID-Chips mit den Antennenabgriffen verbunden werden. Der RFID-Chip fungiert dabei als Brücke zwischen den beiden Antennenabgriffen über die zwischen den Antennenabgriffen gelegenen weiteren Wicklungen der Antenne.

Das Dokument DE 10 2011 016 512 A1 beschreibt ein Verfahren zum Erzeugen einer Durchkontaktierung in einer beidseitig mit Leiterbahnen bedruckten Trägerfolie, bei dem zunächst auf einer Seite der Trägerfolie Leiterbahnen aufgedruckt werden.

In Dokument DE 699 19 008 T2 wird eine kontaktlose Chipkarte mit einer auf einer Seite eines Trägermaterials in Form einer Leiterbahn aufgebrachten Antenne vorgeschlagen, die über zwei Durchkontaktierungen und eine die Durchkontaktierungen auf der anderen Seite des Trägermaterials verbindende Brücke kurzgeschlossen ist.

Das Dokument US 6,353,420 B1 beschäftigt sich mit der Herstellung von kontaktlosen Vorrichtungen, wie beispielsweise RFID-Tags oder Chipkarten, umfassend Durchkontaktierungen zum Anschluss einer auf einer Seite des Trägermaterials als Leiterbahn ausgebildeten Antenne.

Das Dokument US 5,266,904 A betrifft das Vorsehen von Kontaktstellen unmittelbar benachbart zu einer Durchkontaktierung zur Überprüfung der Durchkontaktierung mittels geeigneter Messgeräte.

Bei dem Dokument Venkat S: "Laser drilled Microvias Present and Future Laser drilling promises even faster, more flexible and economical microvia manufacturing in the future" handelt es sich um eine Zusammenstellung von Verfahren zur Herstellung von Durchkontaktierungen in Leiterplatten.

Das Dokument US 2012/0111841 A1 erwähnt Perkussionsbohren mit gepulsten CO2-Lasern als Methode zur Herstellung von Durchkontaktierungen.

Aufgabe der vorliegenden Erfindung ist es, ein verbessertes Verfahren zur Herstellung einer Trägerfolie für einen RFID-Chip einzuführen.

Gelöst wird diese Aufgabe durch ein Verfahren gemäß dem Hauptanspruch sowie eine Trägerfolie gemäß dem nebengeordneten Anspruch. Vorteilhafte Weiterbildungen sind Gegenstand der abhängigen Ansprüche.

Die Erfindung beruht auf der Erkenntnis und schließt diese mit ein, dass aufgrund der fortschreitenden Miniaturisierung der RFID-Chips eine Überbrückung der Antennenwicklungen zunehmend schwierig wird, da der Abstand der Kontakte der RFID-Chips häufig geringer ist als der minimale mit vertretbarem Aufwand herstellbare Abstand der beiden Antennenabgriffe der Leiterbahn.

Demnach betrifft die Erfindung ein Verfahren zum Erzeugen einer Durchkontaktierung in einer beidseitig mit Leiterbahnen bedruckten Trägerfolie deren beiden Seiten in zwei Druckschritten mit elektrisch leitendem Material im Bereich der vorgesehenen Durchkontaktierung bedruckt werden, wobei nach dem ersten Druckschritt und spätestens vor dem zweiten Druckschritt ein Durchgangsloch in die Trägerfolie eingebracht wird, welches bei dem oder den darauffolgenden Druckschritten zur Durchkontaktierung mit elektrisch leitendem Material gefüllt wird, wobei das bereits aufgebrachte elektrisch leitende Material erhalten bleibt, wobei die Druckschritte nacheinander erfolgen und das Einbringen des Durchgangslochs mittels Perkussionsbohren mit einem CO2-Laser erfolgt, wobei für das Einbringen des Durchgangloches als Prozessparameter gewählt sind: Wellenlänge des Lasers 1 bis 100 Mikrometer, Strahldurchmesser 100 bis 500 Mikrometer, Laserleistung 50 bis 500 Watt, Pulsweite 3 bis 10 Mikrosekunden, Anzahl der Schüsse 5 bis 100, Wiederholfrequenz 1 bis 100 Kilohertz, und Anstiegs- und Abfallzeit pro Puls weniger als 70 Mikrosekunden.

Es wird weiterhin eine Trägerfolie offenbart, welche beidseitig mit Leiterbahnen bedruckt ist und wenigstens eine erfindungsgemäß hergestellte Durchkontaktierung aufweist.

Die Erfindung hat erkannt, dass bei einer beidseitig bedruckten Trägerfolie das während der beiden Druckschritte aufgebrachte elektrisch leitende Material ausreichend ist, eine sichere elektrisch leitende Verbindung zwischen den beiden Seiten der Trägerfolie in Form einer Durchkontaktierung, sofern dafür vor einem der Druckschritte wenigstens ein geeignetes Durchgangsloch geschaffen wird. Das Durchgangsloch wird dabei vorteilhafterweise so gestaltet, dass es allein durch das in einem einzelnen Druckschritt aufgebrachte elektrisch leitende Material derart gefüllt wird, dass das im Durchgangsloch befindliche elektrisch leitende Material mit dem im selben Druckschritt benachbart zum Durchgangloch aufgebrachten Material elektrisch verbunden bleibt. Entsprechendes kann durch geeignete Dimensionierung des Durchgangsloches, dessen Tiefe der Dicke der Trägerfolie entspricht, gewährleistet werden. Die Dimensionierung des Durchgangsloches kann von der mit der Durchführung betrauten Fachperson in Abhängigkeit der Dicke der Trägerfolie und der Viskosität des aufgedruckten elektrisch leitenden Materials geeignet gewählt werden.

Das Einbringen des Durchgangsloches in die Trägerfolie kann grundsätzlich vor oder nach dem ersten Druckschritt erfolgen, womit es dann entweder im ersten oder im zweiten Druckschritt mit elektrisch leitendem Material gefüllt wird. Erfindungsgemäß erfolgt das Einbringen des Durchgangsloches in die Trägerfolie nach dem ersten Druckschritt. Das Verfahren lässt sich so flexibel in bereits bestehende Prozesse integrieren. Die beiden Druckschritte werden erfindungsgemäß nacheinander ausgeführt, d. h. zunächst werden in einem ersten Druckschritt Leiterbahnen auf die eine Seite der Trägerfolie aufgebracht, bevor nach Abschluss des ersten Druckschritts in einem zweiten Druckschritt Leiterbahnen auf die andere Seite der Trägerfolie aufgebracht werden. Es ist aber auch möglich, dass die Druckschritte gleichzeitig oder sich zeitlich überlappend ausgeführt werden.

Erfolgt das Einbringen des Durchgangsloches nach dem ersten Druckschritt, bleibt dabei erfindungsgemäß das im ersten Druckschritt aufgebrachte elektrisch leitende Material erhalten. Das Material aus dem ersten Druckschritt bildet also einen elektrisch leitenden Abschluss des Durchgangslochs, der eine gute elektrische Verbindung mit dem im zweiten Druckschritt in das Durchgangsloch eingebrachten elektrisch leitenden Material gewährleistet. Das Einbringen des Durchgangslochs muss dabei derart genau erfolgen, dass einerseits die Trägerfolie im Bereich des Durchgangsloches vollständig entfernt wird, gleichzeitig aber das im ersten Druckschritt aufgebrachte elektrisch leitende Material möglichst vollständig erhalten bleibt, um durch anschließendes Auffüllen des Durchgangslochs mit elektrisch leitendem Material die gewünschte Durchkontaktierung erreicht werden kann.

Alternativ ist es gemäß einem Aspekt der Beschreibung möglich, wenn sich das Durchgangsloch bei Einbringen nach dem ersten Druckschritt auch durch das bereits aufgebrachte elektrisch leitendende Material erstreckt. In diesem Fall bestehen keine besonderen Anforderungen an die Genauigkeit der Tiefe des Durchgangslochs. Auch hat sich gezeigt, dass sich ein Durchgangsloch mit dem im darauffolgenden zweiten Druckschritt aufgebrachten elektrisch leitenden Material zuverlässiger füllen lässt als bei einer von dem im ersten Druckschritt aufgebrachte elektrisch leitende Material abgeschlossen Kavität.

Erfolgt das Einbringen des Durchgangslochs vor dem ersten Druckschritt oder erstreckt sich das Durchgangsloch bei Einbringen nach dem ersten Druckschritt auch durch das bereits aufgebrachte elektrisch leitendende Material, ist bevorzugt, wenn das Durchgangsloch derart dimensioniert ist, dass das im darauffolgenden ersten oder zweiten Druckschritt aufgebrachte elektrisch leitende Material nicht durch das Durchgangsloch durchschießt. In anderen Worten soll das auf einer Seite der Trägerfolie aufgedruckte elektrisch leitende Material im Wesentlichen nicht durch das Durchgangsloch hindurch und frei auf der anderen Seite hinaustreten; vielmehr soll es in dem Durchgangsloch verbleiben, um dieses auszufüllen. Dies kann regelmäßig durch einen ausreichend kleinen, an die Fließeigenschaften des elektrisch leitenden Materials während des Druckvorgangs angepassten Querschnitt des Durchgangslochs insgesamt oder zumindest an der anderen Seite erreicht werden. Beispielsweise kann das Durchgangsloch kegelstumpfförmig mit einem zu der anderen Seite hin abnehmenden Querschnitt geformt werden.

Der Durchmesser des Durchgangslochs kann 50 Mikrometer bis 5000 Mikrometer betragen. Insbesondere, wenn das Durchgangsloch nach dem ersten Druckschritt unter Erhaltung des dabei aufgebrachten elektrisch leitenden Materials eingebracht wird, ist bevorzugt, wenn der Durchmesser des Durchgangslochs 100 Mikrometer bis 500 Mikrometer, weiter bevorzugt 200 Mikrometer bis 400 Mikrometer beträgt. Durch einen entsprechenden Durchmesser ist eine sichere Durchkontaktierung mit hohem elektrischem Leitwert gewährleistet. Die Gefahr eines Durchschießens des im zweiten Druckschritt aufgebrachten Materials besteht in diesem Fall nicht. Insbesondere in den Fällen, in dem ein Durchschießen grundsätzlich möglich ist, beträgt der Durchmesser des Durchgangslochs vorzugsweise 50 Mikrometer bis 200 Mikrometer. Bei üblichen, für Druckverfahren verwendeten elektrisch leitenden Materialien kann dadurch ein Durchschießen des Materials vermieden werden. Die Dicke der Trägerfolie beträgt vorzugsweise 20 Mikrometer bis 500 Mikrometer, weiter vorzugsweise 20 Mikrometer bis 250 Mikrometer, weiter vorzugsweise 50 Mikrometer bis 150 Mikrometer, weiter vorzugsweise 50 Mikrometer bis 100 Mikrometer, sodass ein möglichst weitgehendes bis vollständiges Füllen des Durchgangslochs durch in einem Druckschritt aufgebrachtes elektrisch leitendes Material sichergestellt ist. Die Dicke der in einem Druckschritt aufgebrachten Schicht an elektrisch leitendem Material beträgt vorzugsweise 5 bis 50 Mikrometer, weiter vorzugsweise 5 bis 20 Mikrometer.

Auch wenn vorstehend Maße für den Durchmesser des Durchgangsloches angegeben sind, die die Formgebung des Durchgangsloches nicht auf die bevorzugte kreisrunde Ausgestaltung beschränkt.

Im Falle eines nicht kreisrunden Durchgangslochs ist auf die mit den Durchmesserangaben unmittelbar verknüpfte Querschnittsfläche des Durchgangsloches abzustellen, also vorzugsweise 0,002 Quadratmillimeter bis 20,0 Quadratmillimeter, weiter vorzugsweise 0,008 Quadratmillimeter bis 0,2 Quadratmillimeter oder 0,002 Quadratmillimeter bis 0,03 Quadratmillimeter.

Letztendlich ist die Geometrie des Durchgangsloches so zu wählen, das eventuelle Veränderungen der Geometrie des Durchgangsloches und/oder der Durchkontaktierung in nachfolgenden Prozessschritten - wie bspw. Heißlaminieren - derart vorausschauend berücksichtigt sind, dass die Durchkontaktierung und/oder der gewünschte elektrische Leitwert auch nach den entsprechenden Prozessschritten noch zuverlässig erreicht wird.

Das Einbringen des Durchgangslochs kann beispielsweise durch Stanzen, Bohren oder Lasern, vorzugsweise CO2-Lasern, erfolgen, wobei das Lasern aufgrund der dabei regelmäßig erreichbaren Genauigkeit bevorzugt ist. Insbesondere wenn beim Einbringen im ersten Druckschritt aufgebrachtes elektrisch leitendes Material möglichst weitgehend erhalten bleiben soll, ist das Durchgangsloch bevorzugt durch Lasern einzubringen, da dabei auch die erforderliche Genauigkeit hinsichtlich der Tiefe des Durchgangslochs ohne weiteres eingehalten werden kann.

Bei dem Einbringen des Durchgangslochs mittels Lasern ist es weiterhin vorteilhaft, wenn die Prozessparameter derart gewählt werden, dass der Laser das Material der Trägerfolie selektiv mit hoher Genauigkeit entfernt, ohne das evtl. bereits aufgetragenes elektrisch leitendes Material unbeabsichtigt zerstört oder hinsichtlich seiner elektrischen Eigenschaften verändert wird. Außerdem sollte das Durchgangsloch unmittelbar nach dem Einbringen ausreichend rein sein, um ohne zusätzliche Prozessschritte nachfolgendend mit elektrisch leitendem Material gefüllt werden zu können. Nicht zuletzt ist es vorteilhaft, wenn die vorstehenden Anforderungen auch bei einem schnellen Prozess für eine effektive Fertigung erreicht werden können.

Es hat sich gezeigt, dass die genannten Anforderungen durch Perkussionsbohren mit einem CO2-Laser gut erfüllt werden können. Dabei wird ein gemäß der gewünschten Geometrie des zu schaffenden Durchgangsloches vorgeformter CO2-Laserstrahl - etwa ein kreisrunder Strahl mit einem Durchmesser entsprechend dem gewünschten Durchmesser des Durchgangslochs - mehrmals auf die Stelle des zu schaffenden Durchgangsloches auf der Trägerfolie gepulst, bis das gewünschte Durchgangsloch geschaffen ist. Auf ein Wobbeln oder Trepanieren eines gegenüber der gewünschten Geometrie des Durchgangsloches kleineren Laserstrahls wird dabei verzichtet.

Die Leistung, die Wiederholrate, die Anzahl der Schüsse und der zeitliche Verlauf des Pulses sind dabei vorzugsweise so zu wählen, dass das Material der Trägerfolie verdampft, ohne dass die dabei entstehende Wärme zu unerwünscht großem Ablationsauswurf im Randbereich des zu schaffenden Durchgangsloches führt und/oder es zu unerwünscht hoher mechanischer Belastung von ggf. bereits auf die Trägerfolie aufgebrachtem elektrisch leitenden Material führt.

Erfindungsgemäß erfolgt das Einbringen des Durchgangslochs mittels Perkussionsbohren mit einem CO2-Laser. wobei für das Einbringen des Durchgangloches als Prozessparameter gewählt sind: Wellenlänge des Lasers 1 bis 100 Mikrometer, Strahldurchmesser 100 bis 500 Mikrometer, Laserleistung 50 bis 500 Watt, Pulsweite 3 bis 10 Mikrosekunden, Anzahl der Schüsse 5 bis 100, Wiederholfrequenz 1 bis 100 Kilohertz, und Anstiegs- und Abfallzeit pro Puls weniger als 70 Mikrosekunden.

Es hat sich als weiter vorteilhaft herausgestellt, wenn für das Einbringen des Durchgangloches wenigstens ein Prozessparameter gewählt ist aus der Gruppe bestehend aus: Wellenlänge des Lasers 10 bis 11 Mikrometer, Strahldurchmesser 200 bis 400 Mikrometer, Laserleistung 100 bis 200 Watt, Pulsweite vorzugsweise 5 bis 7 Mikrosekunden, Anzahl der Schüsse 10 bis 30, Wiederholfrequenz 4 bis 8 Kilohertz. Dabei ist die Kombination der Prozessparameter der Anzahl der Schüsse sowie der Pulsweite in den genannten Bereichen besonders relevant und bevorzugt, da sich aus der entsprechenden Kombination unmittelbar ergibt, dass das Einbringen des Durchgangslochs in einer Vielzahl kleiner Schritte, in denen jeweils nur ein kleiner Teil des Materials abgetragen wird, erfolgt. Weiter bevorzugt ist die Wiederholfrequenz in dem genannten Bereich gewählt. Durch eine entsprechende Wiederholfrequenz bei der bevorzugten Pulsweite kann die thermische Belastung des Materials der Trägerfolie gering gehalten werden.

Um dauerhaft gleichbleibende Resultate zu erreichen, ist es bevorzugt, wenn während dem Einbringen eines Durchgangslochs mittels Laser, die Trägerfolie auf einer Metalloberfläche, bspw. einem Metalltisch, aufliegt, um eine gleichmäßige und reproduzierbare Wärmeableitung zu gewährleisten. Um zu verhindern, dass sich beim Laser entstehende Dämpfe oder Rauch auf der Trägerfolie als Verschmutzung ablagern, ist weiterhin bevorzugt, wenn die Trägerfolie während des Einbringens eines Durchgangsloches von Luft oder einem anderen Gas, bspw. einem Inert-Gas, überströmt wird, mit dem evtl. entstehende Dämpfe bzw. Rauch sofort aus der Bearbeitungszone transportiert werden.

Es ist bevorzugt, wenn das elektrisch leitende Material Silberleitpaste ist. Silberleitpaste eignet sich gut für den Druck von Leiterbahnen. Insbesondere, wenn das Durchgangsloch per CO2-Laser eingebracht wird, bietet die Verwendung von Silberleitpaste als elektrisch leitendes Material den Vorteil, dass es bei Auftreffen des Lasers aufgrund der der üblichen Wellenlänge von CO2-Lasern nur wenig oxidiert und, wenn überhaupt, nur kaum ablatiert wird.

Die Trägerfolie ist bevorzugt aus Polycarbonat. Eine Trägerfolie aus Polycarbonat kann mit weiteren Lagen aus Polycarbonat durch Laminieren zu einem als Schichtverbund aufgebauten RFID-Sicherheitsdokument verbunden werden, ohne dass sich eine erhöhte Gefahr von Delaminationen aufgrund inkompatibler Materialien der Schichten des Schichtverbundes ergäbe.

Die offenbarte, beidseitig mit Leiterbahnen bedruckte Trägerfolie weist wenigstens eine erfindungsgemäß hergestellte Durchkontaktierung auf. Zur weiteren Erläuterung wird auf die vorstehenden Ausführungen verwiesen.

Da der elektrische Leitwert einer Durchkontaktierung aufgrund der für das erfindungsgemäße Verfahren erforderlichen Dimensionierung des Durchgangsloches für eine vorgesehene Verwendung ggf. zu gering ist, ist es möglich, jeweils eine Leiterbahn auf unterschiedlichen Seiten der Trägerfolie durch ein Feld von wenigstens zwei Durchkontaktierungen elektrisch miteinander zu verbinden. Die vorzugsweise eng benachbart zueinander angeordneten Durchkontaktierungen stellen so parallele Verbindungen zwischen den beiden Leiterbahnen her, wodurch sich ein erhöhter kumulierter elektrischer Leitwert zwischen den beiden Leiterbahnen ergibt. Zudem ergibt sich eine Redundanz der Durchkontaktierungen, wodurch eine ungenügende Kontaktierung in einer Durchkontaktierung durch eine gelungene Kontaktierung in einer anderen Durchkontaktierung aufgefangen wird.

Es ist weiter bevorzugt, wenn zwei durch wenigstens eine Durchkontaktierung verbundene Leiterbahnen auf der Trägerfolie Kontaktstellen zur Überprüfung der Durchkontaktierung(en) umfassen. An den Kontaktstellen können Prüfspitzen eines Messgerätes angelegt werden und so das grundsätzliche Bestehen einer elektrischen Verbindung über die Durchkontaktierung(en) und/oder der elektrische Widerstand bzw. der elektrische Leitwert der Durchkontaktierung(en) überprüft werden.

Die Erfindung wird nun anhand vorteilhafter Ausführungsformen unter Bezugnahme auf die beigefügten Zeichnungen beispielhaft beschrieben. Es zeigen:
- Figur 1:: eine schematische Darstellung eines Ausführungsbeispiels eines RFID-Inlays mit einer offenbarten Trägerfolie;
- Figur 2a:: eine schematische Detaildarstellung der Trägerfolie aus Figur 1;
- Figur 2b:: eine schematische Detaildarstellung einer Ausführungsvariante zu Figur 2a; und
- Figuren 3a-c:: schematische Darstellungen verschiedener Durchführungen des erfindungsgemäßen Verfahrens (Figur 3a) sowie von Verfahren gemäß Aspekten der Beschreibung zum Erzeugen einer Durchkontaktierung in einer beidseitig mit Leiterbahnen bedruckten Trägerfolie.

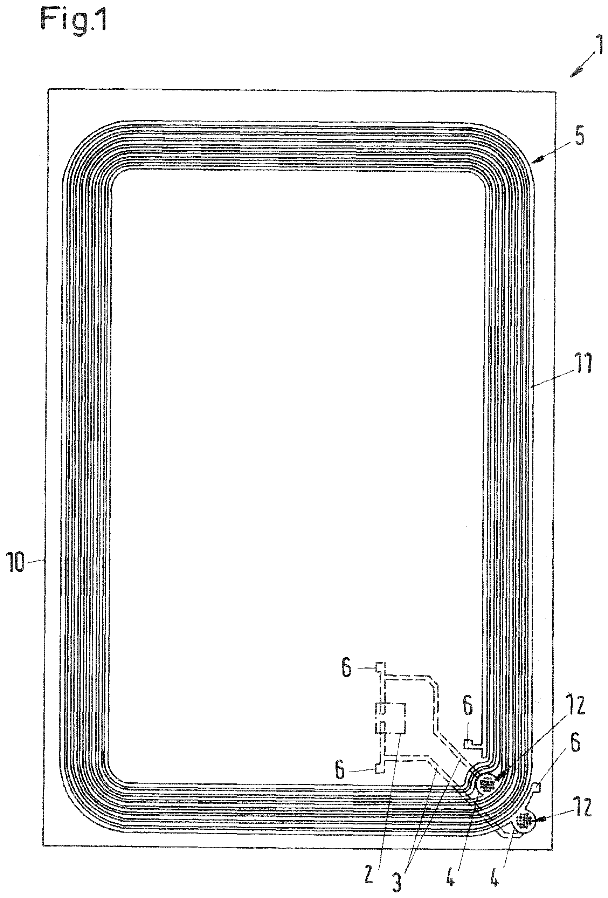

In Figur 1 ist ein RFID-Inlay 1, wie es in Sicherheitsdokumenten (bspw. Reisepässen) Verwendung findet, dargestellt. Das RFID-Inlay 1 umfasst eine offenbarte Trägerfolie 10, beidseitig mit Leiterbahnen 11 bedruckt ist. In Figur 1 sind die Leiterbahnen 11 auf der unmittelbar sichtbaren Vorderseite der Trägerfolie 10 in durchgezogenen Linien, die Leiterbahnen 11 auf der Rückseite der Trägerfolie 10 in ge strichelten Linien dargestellt. Das RFID-Inlay 1 umfasst weiterhin den lediglich mit einer Strichpunktlinie angedeuteten RFID-Chip 2, der auf der Rückseite der Trägerfolie 10 angeordnet ist.

Der RFID-Chip 2 des RFID-Inlays 1 ist über Zuleitungen 3 mit Antennenabgriffen 4 einer Antenne 5 verbunden, wobei letztere neben Kommunikationszwecken auch der Energieversorgung dient. Die Zuleitungen 3, die Antennenabgriffe 4 und die Antenne 5 selbst sind durch die auf die Trägerfolie 10 aufgedruckten Leiterbahnen 11 gebildet. Auf der Vorderseite der Trägerfolie 10 ist die Leiterbahn 11 zur Bildung der Antenne 3 spulenförmig ausgestaltet und an den Antennenabgriffen 4 zu lediglich beispielhaft kreisförmig geformten Feldern erweitert. Auf der Rückseite sind die Leiterbahnen 11 als zwei separate Zuleitungen 3 ausgestaltet, die jeweils an ihrem einen Ende (in Figur 1 durch die Antennenabgriffe 4 verdeckte) kreisförmige Felder analog zu den Antennenabgriffen 4 auf der Vorderseite aufweisen. In dem gezeigten Ausführungsbeispiel sind die beiden Zuleitungen 3 an ihren anderen Enden auf einer gemeinsamen Achse aufeinander zulaufend ausgestaltet. Durch diese optionale, aber bevorzugte Ausgestaltung kann die Trägerfolie 10 flexibel mit verschiedenen RFID-Chips 2 bestückt werden, da durch das Layout der Leiterbahnen 11 kein Abstand für die Kontakte des RFID-Chips 2 vorgeschrieben ist, sondern RFID-Chips 2 mit unterschiedlichen Kontaktabständen so auf der Trägerfolie 10 angeordnet werden können, dass jeweils ein Kontakt mit einer Zuleitung 3 verbunden ist.

Zur Verbindung der Leiterbahnen 11 auf der Vorder- und Rückseite der Trägerfolie 10 sind im Bereich der Antennenabgriffe 4 Felder von Durchkontaktierungen 12 vorgesehen, mit denen die Antennenabgriffe 4 elektrisch mit den Zuleitungen 3 und somit die Antenne 5 mit dem RFID-Chip 2 verbunden werden.

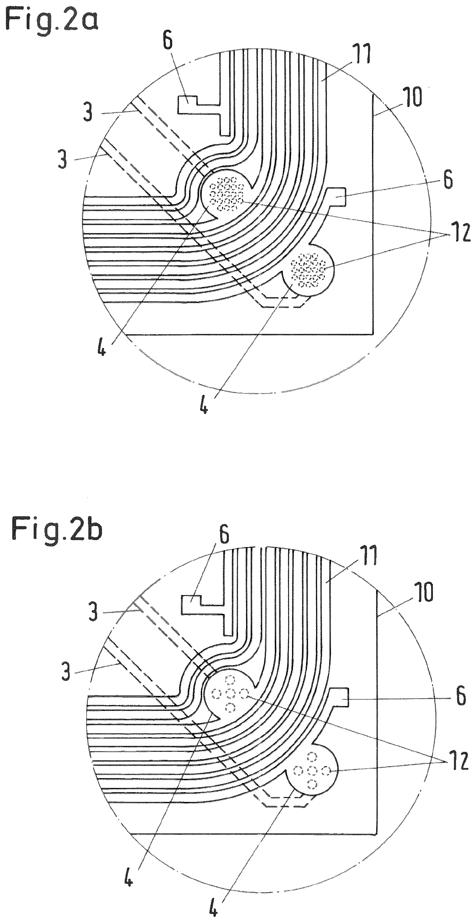

In Figuren 2a und b sind zwei verschiedene Ausführungsvarianten für das Feld von Durchkontaktierungen 12 in schematischen Detailansichten gezeigt, wobei die Variante aus Figur 2a der Darstellung aus Figur 1 entspricht. Die an sich durch die Leiterbahn 11 auf der Vorderseite verdeckten Durchkontaktierungen 12 sind durch Punktlinien angedeutet.

In der Ausführungsvariante gemäß Figur 2a sind im Bereich jedes Antennenabgriffs 4 jeweils 21 Durchkontaktierungen 12 vorgesehen, wobei jede Durchkontaktierung 12 einen Durchmesser von etwa 140 Mikrometer aufweist. In der Ausführungsvariante gemäß Figur 2b sind im Bereich jedes Antennenabgriffs 4 nur jeweils fünf Durchkontaktierungen 12 vorgesehen. Da diese aber jeweils einen Durchmesser von etwa 285 Mikrometer aufweisen, ist der kumulierte elektrische Leitwert eines jeweiligen Feldes von Durchkontaktierungen 12 unter Annahme identischer Materialen und Dicke der Trägerfolie 10 bei beiden Ausführungsvarianten praktisch identisch. Die Erfindung ist nicht auf die gezeigten Zahlen von Durchkontaktierungen 12 beschränkt und kann im Einzelfall mit abweichenden Konstellationen verwirklicht werden.

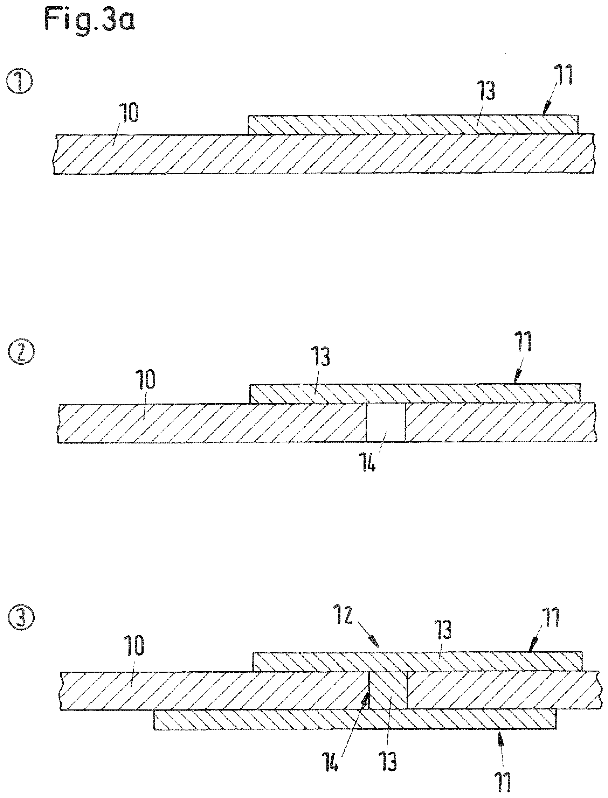

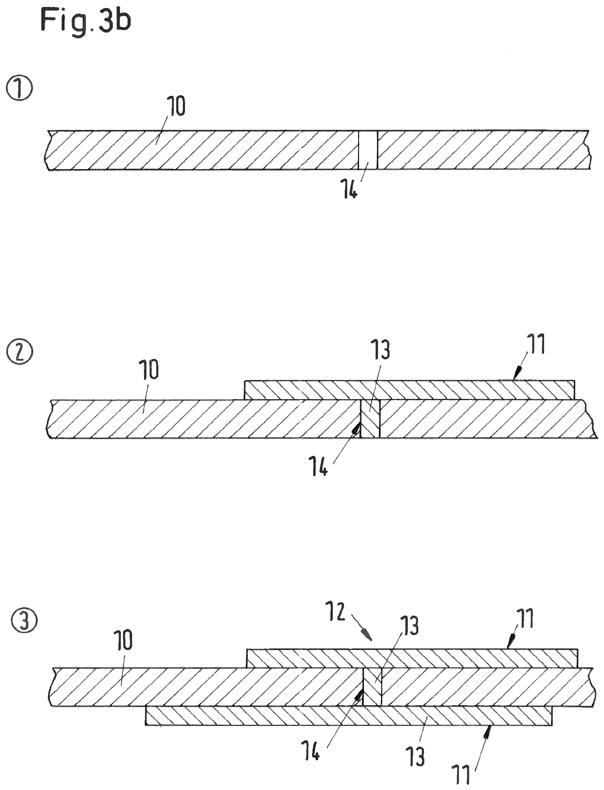

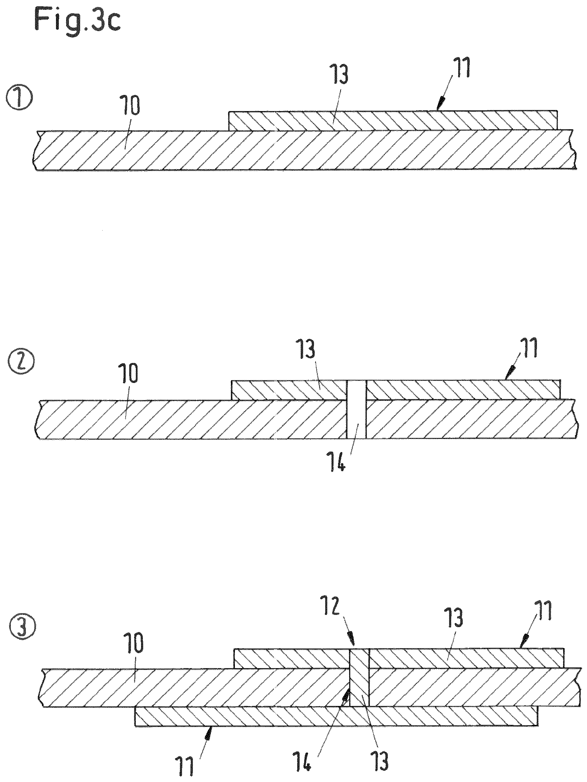

Die Durchkontaktierungen 12 der Trägerfolie 10 des RFID-Chips aus Figuren 1 und 2a, b sind in einem erfindungsgemäßen Verfahren, wie anhand der Figur 3a erläutert, erzeugt worden. Zwei unterschiedliche Durchführungsvarianten eines Verfahrens gemäß einem Aspekt der Beschreibung werden anhand der Figuren 3b und c erläutert.

Beim in Figur 3a dargestellten Verfahren wird in einem ersten Schritt eine erste Seite der Trägerfolie 10 mit einem elektrisch leitenden Material 13 zur Bildung von Leiterbahnen 11 bedruckt, wobei insbesondere im zur Durchkontaktierung vorgesehenen Bereich elektrisch leitendes Material 13 aufgedruckt ist (Figur 3a.1). Anschließend wird ein Durchgangsloch 14 in die Trägerfolie 10 eingebracht, wobei jedoch das zuvor aufgebrachte elektrisch leitende Material 13 wenigstens nahezu vollständig erhalten bleibt (Figur 3a.2). Das Einbringen des Durchgangslochs 14 kann per CO2-Laser durchgeführt werden und hat sich als ausreichend genau erwiesen. Anschließend wird die zweite Seite der Trägerfolie 10 mit einem elektrisch leitenden Material 13 zur Bildung von Leiterbahnen 11 bedruckt, wobei sich der Materialauftrag insbesondere auch über das Durchgangsloch 14 erstreckt. Durch das Aufbringen des elektrisch leitenden Materials 13 in dem zweiten Druckvorgang wird das Durchgangsloch 14 möglichst weitgehend, vorzugsweise vollständig mit elektrisch leitendem Material 13 gefüllt, sodass eine elektrische Verbindung zwischen den Leiterbahnen 11 auf beiden Seiten der Trägerfolie geschaffen wird (Figur 3a.3).

Da das Durchgangsloch 14 durch das vor dessen Einbringung bereits aufgetragene elektrisch leitende Material 13 auf der einen Seite geschlossen ist, ist für die Dimensionierung des Durchgangslochs 14 lediglich zu berücksichtigen, dass es durch das im zweiten Druckschritt aufgebrachte elektrisch leitende Material 13 hinreichend gefüllt werden kann und eine gute elektrische Verbindung der so geschaffenen Durchkontaktierung 12 mit den benachbarten Leiterbahnen 11 gewährleistet ist. Der Durchmesser des Durchgangslochs 14 in Figur 3a beträgt ca. 285 Mikrometer (vgl. Figur 2b). Mit dieser Verfahrensdurchführung sind unter der Voraussetzung, dass das Durchgangsloch 14 in einem Druckschritt mit elektrisch leitendem Material 13 gefüllt wird, aber auch beliebige andere Durchmesser realisierbar, bspw. auch etwa 140 Mikrometer (vgl. Figur 2a).

In Figur 3b ist eine alternative Durchführung des Verfahrens zum Erzeugen einer Durchkontaktierung 12 in einer beidseitig mit Leiterbahnen 11 bedruckten Trägerfolie 10 dargestellt.

Dabei wird bereits im ersten Schritt vor jeglichem Aufbringen von elektrisch leitendem Material 13 ein Durchgangsloch 14 in die Trägerfolie 10 eingebracht (Figur 3b.1). Das Durchgangsloch 14 kann durch Lasern, Bohren oder Stanzen eingebracht werden. Insbesondere kann auch bei diesem Verfahren das Durchgangsloch 14 mittels CO2-Laser geschaffen werden. Anschließend wird die erste Seite der Trägerfolie 10 mit elektrisch leitendem Material 13 bedruckt, wobei sich auch das Durchgangsloch 14 mit diesem Material 13 füllt (Figur 3b.2). Um zu vermeiden, dass das in diesem Schritt aufgebrachte elektrisch leitende Material 13 auf der zweiten Seite der Trägerfolie 10 unmittelbar wieder austritt - also durch das Durchgangsloch 14 hindurchschießt - ist das Durchgangsloch 14 entsprechend dimensioniert. Insbesondere ist der Durchmesser des Durchgangslochs 14 an der zweiten Seite der Trägerfolie 10 an die Fließeigenschaften des elektrisch leitenden Materials 13 während des Druckvorganges und die Dicke der Trägerfolie geeignet angepasst. Abschließend wird die zweite Seite der Trägerfolie 10 in einem zweiten Druckschritt mit elektrisch leitendem Material bedruckt, sodass sich die gewünschte Durchkontaktierung ergibt (Figur 3b.3).

Bei der in Figur 3c dargestellten Durchführungsvariante des Verfahrens wird in einem ersten Schritt zunächst auf der ersten Seite der Trägerfolie 10 elektrisch leitendes Material 13 aufgedruckt (Figur 3c.1). Anschließend wird ein Durchgangsloch 14 eingebracht, wobei sich dieses Durchgangsloch 14 jedoch nicht nur durch die Trägerfolie 10 sondern auch durch das zuvor aufgebrachte elektrisch leitende Material 13 erstreckt (Figur 3c.2). Auch hier kann das Durchgangsloch 14 mittels CO2-Laser geschaffen werden, wobei zum Durchdringen auch des zuvor aufgebrachten elektrisch leitenden Materials 13 ggf. andere Prozessparameter als bei den vorstehenden Ausführungsvarianten zu wählen sind. In einem zweiten Druckschritt wird dann elektrisch leitendes Material 13 auf die zweite Seite der Trägerfolie 10 aufgedruckt, wobei auch das Durchgangsloch 14 gefüllt wird (Figur 3c.3). Da das Durchgangsloch 14 während des zweiten Druckschritts auf der ersten Seite der Trägerfolie 10 offen ist, wird ein Durchschießen des elektrisch leitenden Materials 13 durch geeignete Dimensionierung des Durchgangslochs 14 vermieden. Es wird auf die diesbezüglichen Erläuterungen zu Figur 3b.2 verwiesen.

Bei sämtlichen vorstehend erläuterten Ausführungsbeispielen ist die Trägerfolie 10 bevorzugt aus Polycarbonat und weist eine Dicke von etwa 100 Mikrometer auf. Bei dem elektrisch leitenden Material 13 handelt es sich durchgehend bevorzugt um Silberleitpaste, die mit einer Schichtdicke von ca. 20 Mikrometer aufgebracht wird. Unter diesen Voraussetzungen kann ein Durchschießen des elektrisch leitenden Materials 13 durch das Durchgangsloch 14 bspw. vermieden werden, wenn der Durchmesser des Durchgangslochs 14 zwischen 100 und 200 Mikrometer, beispielsweise etwa 140 Mikrometer, beträgt. In der Folge eignen sich die in Figuren 3b und 3c gezeigten Durchführungen des Verfahrens besonders für die in Figur 2a gezeigte Ausgestaltungsvariante eines Feldes von Durchkontaktierungen 12. Bei der Ausgestaltungsvariante gemäß Figur 2b ist das Risiko des Durchschießens von elektrisch leitendem Materials 13 durch das Durchgangsloch 14 aufgrund dessen größeren Durchmessers deutlich höher.

Für das Einbringen der Durchgangslöcher 14 wird vorzugsweise ein CO2-Laser mit den folgenden Prozessparametern verwendet:

| | |
|---|---|
| Wellenlänge des Lasers | 10 bis 11 Mikrometer |
| Strahldurchmesser | = Durchmesser Durchgangslochs 14 |
| Laserleistung | 100 bis 200 Watt |
| Pulsweite | 5 bis 7 Mikrosekunden |
| Anzahl der Schüsse | 10 bis 30 |
| Wiederholfrequenz | 4 bis 8 Kilohertz |
| Anstiegs/-Abfallzeit | < 70 Mikrosekunden pro Puls |

Für das Durchdringen auch des elektrisch leitenden Materials 13 bei der in Figur 3c dargestellten Durchführungsvariante ist eine höhere Anzahl an Schüssen erforderlich als bei den beiden anderen Durchführungsvarianten gemäß Figuren 3a, b, bei denen das Durchgangsloch 14 nur in die Trägerfolie 10 eingebracht werden muss.

Unabhängig von der Ausführungsvariante für das Feld von Durchkontaktierungen 12 (Figur 2a, b) und der letztendlichen Durchführung des erfindungsgemäßen Verfahrens zur Erzeugung der Durchkontaktierungen 12 (Figur 3a) umfassen die Leiterbahnen 11 der in Figur 1 dargestellte Trägerfolie 10 vorteilhafte, jedoch im Rahmen der Erfindung optionale Kontaktstellen 6 für die Prüfspitzen eines Messgerätes (nicht dargestellt). Durch geeignetes Anlegen der beiden Prüfspitzen eines Messgerätes kann die elektrische Verbindung zwischen jeweils zwei dieser Kontaktstellen 6 und somit - je nach Wahl der Kontaktstellen 6 - auch jeweils ein Feld von Durchkontaktierungen 12 überprüft werden. Neben der Feststellung des Bestehens einer elektrischen Verbindung durch die Durchkontaktierungen 12 kann bei Bedarf auch der elektrische Leitwert für ein Feld von Durchkontaktierungen 12 ermittelt werden.

### Bezugszeichenliste

- 1: RFID-Inlay
- 2: RFID-Chip
- 3: Zuleitung
- 4: Antennenabgriff
- 5: Antenne
- 6: Kontaktstellen
- 10: Trägerfolie
- 11: Leiterbahn
- 12: Durchkontaktierung
- 13: elektrisch leitendes Material
- 14: Durchgangsloch

## Patentansprüche

1. Verfahren zum Erzeugen einer Durchkontaktierung (12) in einer beidseitig mit Leiterbahnen (11) bedruckten Trägerfolie (10), deren beiden Seiten in jeweils einem von zwei Druckschritten mit elektrisch leitendem Material (13) im Bereich der vorgesehenen Durchkontaktierung (12) bedruckt werden, wobei nach dem ersten Druckschritt und spätestens vor dem zweiten Druckschritt ein Durchgangsloch (14) in die Trägerfolie (10) eingebracht wird, welches bei dem oder den darauffolgenden Druckschritt(en) zur Durchkontaktierung mit elektrisch leitendem Material (13) gefüllt wird, wobei das bereits aufgebrachte elektrisch leitende Material (13) erhalten bleibt, **dadurch gekennzeichnet, dass**
die Druckschritte nacheinander erfolgen und das Einbringen des Durchgangslochs (14) mittels Perkussionsbohren mit einem CO2-Laser erfolgt, wobei für das Einbringen des Durchgangloches als Prozessparameter gewählt sind: Wellenlänge des Lasers 1 bis 100 Mikrometer, Strahldurchmesser 100 bis 500 Mikrometer, Laserleistung 50 bis 500 Watt, Pulsweite 3 bis 10 Mikrosekunden, Anzahl der Schüsse 5 bis 100, Wiederholfrequenz 1 bis 100 Kilohertz, und Anstiegs- und Abfallzeit pro Puls weniger als 70 Mikrosekunden.

2. Verfahren nach Anspruch 1,
**dadurch gekennzeichnet, dass**
jeweils eine Leiterbahn (11) auf unterschiedlichen Seiten der Trägerfolie (10) durch ein Feld von wenigstens zwei Durchkontaktierungen (12) elektrisch miteinander verbunden sind.

3. Verfahren nach einem der vorhergehenden Ansprüche,
**dadurch gekennzeichnet, dass**
der Durchmesser des Durchgangslochs (14) 50 Mikrometer bis 5000 Mikrometer, vorzugsweise 50 Mikrometer bis 200 Mikrometer oder 100 Mikrometer bis 500 Mikrometer beträgt, und/oder der Durchmesser des Durchgangslochs (14) dem Strahldurchmesser entspricht, und/oder dass die Dicke der Trägerfolie (10) 20 Mikrometer bis 250 Mikrometer, vorzugsweise 75 Mikrometer bis 125 Mikrometer ist.

4. Verfahren nach einem der vorhergehenden Ansprüche,
**dadurch gekennzeichnet, dass**
für das Einbringen des Durchgangloches wenigstens ein Prozessparameter gewählt ist aus der Gruppe bestehend aus: Wellenlänge des Lasers 10 bis 11 Mikrometer, Strahldurchmesser 200 bis 400 Mikrometer, Laserleistung 100 bis 200 Watt, Pulsweite 5 bis 7 Mikrosekunden, Anzahl der Schüsse 10 bis 30, Wiederholfrequenz 4 bis 8 Kilohertz.

5. Verfahren nach einem der vorhergehenden Ansprüche,
**dadurch gekennzeichnet, dass**
die Trägerfolie (10) während dem Einbringen des Durchgangslochs (14) auf einer Metalloberfläche aufliegt und/oder von Luft oder einem Gas überströmt wird.

6. Verfahren nach einem der vorhergehenden Ansprüche,
**dadurch gekennzeichnet, dass**
das elektrisch leitende Material (13) Silberleitpaste ist.

7. Verfahren nach einem der vorhergehenden Ansprüche,
**dadurch gekennzeichnet, dass**
die Trägerfolie (10) aus Polycarbonat ist.

8. Verfahren nach einem der vorhergehenden Ansprüche,
**dadurch gekennzeichnet, dass**
jeweils eine Leiterbahn (11) auf unterschiedlichen Seiten der Trägerfolie (10) durch ein Feld von wenigstens zwei Durchkontaktierungen (12) elektrisch miteinander verbunden sind.

9. Verfahren nach einem der vorhergehenden Ansprüche,
**dadurch gekennzeichnet, dass** 21 Durchkontaktierungen (12) vorgesehen sind, wobei jede Durchkontaktierung (12) einen Durchmesser von etwa 140 Mikrometer aufweist, oder dass fünf Durchkontaktierungen (12) vorgesehen sind, wobei jede Durchkontaktierung (12) einen Durchmesser von etwa 285 Mikrometer aufweist.

10. Verfahren nach einem der vorhergehenden Ansprüche,
**dadurch gekennzeichnet, dass**
zwei durch wenigstens eine Durchkontaktierung(en) (12) verbundene Leiterbahnen (11) Kontaktstellen (6) zur Überprüfung der Durchkontaktierung(en) (12) umfassen.

## Claims

1. Method for producing a through connection (12) in a carrier film (10) which is printed on both sides with conductor tracks (11) and the two sides of which are printed in one of two printing steps with electrically conductive material (13) in the area where the through connection (12) is provided, wherein, after the first printing step and at the latest before the second printing step, a through hole (14) is introduced into the carrier film (10) and, in the subsequent printing step(s), the hole is filled with an electrically conductive material (13) for the through connection, while the electrically conductive material (13) already applied is retained, **characterized in that** the printing steps are performed one after the other and the introduction of the through hole (14) takes place by means of percussion drilling with a CO2 laser, with the following being chosen as process parameters for the introduction of the through hole: wavelength of the laser 1 to 100 micrometres, beam diameter 100 to 500 micrometres, laser power 50 to 500 watts, pulse width 3 to 10 microseconds, number of shots 5 to 100, repetition frequency 1 to 100 kilohertz, and rise and fall time per pulse less than 70 microseconds.

2. Method according to Claim 1,
**characterized in that**
a conductor track (11) on one side of the carrier film (10) is electrically connected to one on the other side in each case by an array of at least two through connections (12).

3. Method according to one of the preceding claims,
**characterized in that**
the diameter of the through hole (14) is 50 micrometres to 5000 micrometres, preferably 50 micrometres to 200 micrometres or 100 micrometres to 500 micrometres, and/or the diameter of the through hole (14) corresponds to the beam diameter, and/or **in that** the thickness of the carrier film (10) is 20 micrometres to 250 micrometres, preferably 75 micrometres to 125 micrometres.

4. Method according to one of the preceding claims,
**characterized in that**
at least one process parameter from the following group is chosen for the introduction of the through hole: wavelength of the laser 10 to 11 micrometres, beam diameter 200 to 400 micrometres, laser power 100 to 200 watts, pulse width 5 to 7 microseconds, number of shots 10 to 30, repetition frequency 4 to 8 kilohertz.

5. Method according to one of the preceding claims,
**characterized in that**
during the introduction of the through hole (14), the carrier film (10) rests on a metal surface and/or is flowed over by air or gas.

6. Method according to one of the preceding claims,
**characterized in that**
the electrically conductive material (13) is silver conductive paste.

7. Method according to one of the preceding claims,
**characterized in that**
the carrier film (10) is made of polycarbonate.

8. Method according to one of the preceding claims,
**characterized in that**
a conductor track (11) on one side of the carrier film (10) is electrically connected to one on the other side in each case by an array of at least two through connections (12).

9. Method according to one of the preceding claims, **characterized in that** 21 through connections (12) are provided, wherein each through connection (12) has a diameter of approximately 140 micrometres, or **in that** five through connections (12) are provided, wherein each through connection (12) has a diameter of approximately 285 micrometres.

10. Method according to one of the preceding claims,
**characterized in that**
two conductor tracks (11) connected by at least one through connection (12) comprise contact points (6) for testing the through connection(s) (12).

## Revendications

1. Procédé de production d'un trou d'interconnexion (12) dans une feuille de support (10) imprimée des deux côtés de pistes conductrices (11), dont les deux côtés sont imprimés avec un matériau électriquement conducteur (13) dans la zone du trou d'interconnexion (12) prévu dans respectivement une de deux étapes d'impression, après la première étape d'impression et au plus tard avant la seconde étape d'impression, un trou de passage (14) étant réalisé dans la feuille de support (10), lequel trou de passage est rempli de matériau électriquement conducteur (13) dans la ou les étapes d'impression suivantes pour la réalisation d'un trou d'interconnexion, le matériau électriquement conducteur (13) déjà appliqué restant conservé, **caractérisé en ce que** les étapes d'impression sont effectuées successivement et la réalisation du trou de passage (14) est effectuée au moyen d'un perçage à percussion avec un laser CO2, des paramètres suivants étant choisis comme paramètres de processus pour la réalisation du trou de passage : longueur d'onde du laser 1 à 100 micromètres, diamètre de faisceau 100 à 500 micromètres, puissance du laser 50 à 500 watts, largeur d'impulsion 3 à 10 microsecondes, nombre de tirs 5 à 100, fréquence de répétition 1 à 100 kilohertz, et temps de montée et de descente par impulsion inférieur à 70 microsecondes.

2. Procédé selon la revendication 1,
**caractérisé en ce que**
respectivement des pistes conductrices (11) sur différents côtés de la feuille de support (10) sont reliées électriquement les unes aux autres par un champ d'au moins deux trous d'interconnexion (12).

3. Procédé selon l'une des revendications précédentes,
**caractérisé en ce que**
le diamètre du trou de passage (14) va de 50 micromètres à 5000 micromètres, de préférence de 50 micromètres à 200 micromètres ou de 100 micromètres à 500 micromètres, et/ou le diamètre du trou de passage (14) correspond au diamètre de faisceau, et/ou que l'épaisseur de la feuille de support (10) va de 20 micromètres à 250 micromètres, de préférence de 75 micromètres à 125 micromètres.

4. Procédé selon l'une des revendications précédentes,
**caractérisé en ce que**
au moins un paramètre de processus pour la réalisation du trou de passage est choisi dans le groupe comprenant : longueur d'onde du laser 10 à 11 micromètres, diamètre de faisceau 200 à 400 micromètres, puissance du laser 100 à 200 watts, largeur d'impulsion 5 à 7 microsecondes, nombre de tirs 10 à 30, fréquence de répétition 4 à 8 kilohertz.

5. Procédé selon l'une des revendications précédentes,
**caractérisé en ce que**
la feuille de support (10) repose sur une surface métallique pendant la réalisation du trou de passage (14) et/ou est recouverte par un flux d'air ou de gaz.

6. Procédé selon l'une des revendications précédentes,
**caractérisé en ce que**
le matériau électriquement conducteur (13) est une pâte d'argent conductrice.

7. Procédé selon l'une des revendications précédentes,
**caractérisé en ce que**
la feuille de support (10) est composée de polycarbonate.

8. Procédé selon l'une des revendications précédentes,
**caractérisé en ce que**
respectivement des pistes conductrices (11) sur différents côtés de la feuille de support (10) sont reliées électriquement les unes aux autres par un champ d'au moins deux trous d'interconnexion (12).

9. Procédé selon l'une des revendications précédentes,
**caractérisé en ce que** 21 trous d'interconnexion (12) sont prévus, chaque trou d'interconnexion (12) comportant un diamètre d'environ 140 micromètres, ou que cinq trous d'interconnexion (12) sont prévus, chaque trou d'interconnexion (12) comportant un diamètre d'environ 285 micromètres.

10. Procédé selon l'une des revendications précédentes,
**caractérisé en ce que**
deux pistes conductrices (11) reliées par au moins un trou d'interconnexion (12) comprennent des points de contact (6) servant à vérifier le ou les trous d'interconnexion (12).
